(19) Europäisches Patentamt / European Patent Office / Office européen des brevets

(11) **EP 3 407 486 B1**

(12) **FASCICULE DE BREVET EUROPEEN**

(45) Date de publication et mention de la délivrance du brevet:
**08.07.2020 Bulletin 2020/28**

(51) Int Cl.:
**H03B 5/36** *(2006.01)* **G01R 19/04** *(2006.01)*

(21) Numéro de dépôt: **18166250.3**

(22) Date de dépôt: **09.04.2018**

(54) **CIRCUIT OSCILLATEUR À QUARTZ AUTO-POLARISÉ**

AMPLITUDENGEREGELTE QUARTZ-OSZILLATORSCHALTUNG

OSCILLATOR CIRCUIT WITH SELF-BIASED QUARTZ

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2017 EP 17172736**

(43) Date de publication de la demande:
**28.11.2018 Bulletin 2018/48**

(73) Titulaire: **EM Microelectronic-Marin SA 2074 Marin (CH)**

(72) Inventeurs:
• **Coustans, Mathieu 1003 Lausanne (CH)**
• **Rossi, Luca 1018 Lausanne (CH)**
• **Godat, Yves 2087 Cornaux (CH)**

(74) Mandataire: **ICB SA Faubourg de l'Hôpital, 3 2001 Neuchâtel (CH)**

(56) Documents cités:
FR-A1- 2 305 056      JP-A- S5 957 171
US-A1- 2007 188 256      US-A1- 2008 042 770
US-B1- 6 278 338      US-B1- 7 688 154
US-B1- 9 209 747

EP 3 407 486 B1

**Description**

L'invention concerne un circuit oscillateur à quartz de type auto-polarisé, notamment pour une utilisation horlogère.

ART ANTERIEUR

Généralement, un circuit oscillateur à quartz comprend un inverseur composé de deux transistors complémentaires MOS montés en série avec une source de courant entre deux bornes d'une source de tension d'alimentation pour définir une branche active. Une source d'un des transistors MOS est reliée à la source de courant, alors qu'une source de l'autre transistor est reliée à une des bornes de la source de tension d'alimentation. Les drains des transistors NMOS et PMOS sont reliés en sortie à une première électrode du quartz, alors que les grilles desdits transistors en entrée sont reliées à une seconde électrode du quartz. Traditionnellement un premier condensateur de déphasage est relié à la première électrode du quartz, alors qu'un second condensateur ajustable est relié à la seconde électrode du quartz.

Un tel circuit oscillateur est notamment décrit dans l'état de la technique par le brevet CH 623 450, dans lequel il est également prévu une résistance de polarisation disposée entre les grilles et les drains des transistors de l'inverseur. De par ce montage, une oscillation en tension au niveau du quartz est établie pour produire un signal d'oscillation à fréquence déterminée par la première électrode de sortie du quartz.

La résistance de polarisation doit être de grande valeur pour réduire le courant dans la branche active de l'oscillateur. Cette résistance de polarisation de grande valeur doit notamment être choisie pour ne pas détruire la résistance négative nécessaire, qui est générée par l'inverseur et le courant qui le traverse pour l'entretien de l'oscillation au niveau du quartz. La réalisation d'une telle résistance de grande valeur dans le circuit intégré est un problème, car une place importante est occupée dans le circuit intégré, ce qui est un inconvénient d'un tel circuit oscillateur.

L'amplitude de l'oscillation au niveau du quartz peut être également maintenue par une source de courant adaptable commandée par une unité de régulation. Une forme d'exécution d'une telle unité de régulation est décrite par exemple dans l'article intitulé "Quartz oscillators for watches" de Eric A. Vittoz, publié dans les actes du dixième Congrès International de Chronométrie, Genève, septembre 1979, vol. 3, pages 131 à 140.

Dans l'article intitulé "High-performance crystal oscillator circuits : Theory and application" de Eric A. Vittoz, publié dans le journal IEEE des circuits à l'état solide, centre du service IEEE, Piscataway, NJ, US, vol. 23 no. 3 du 1er juin 1988, il est prévu de disposer entre le drain et la grille d'un transistor MOS M1 d'une branche active du circuit oscillateur, une pseudo-résistance en tant que moyen de polarisation active. Comme représenté à la figure 11 de cet article, cette pseudo-résistance est réalisée par un transistor MOS M17, dont le drain et la source sont reliés respectivement au drain et à la grille du transistor MOS M1. La grille de ce transistor en pseudo-résistance est polarisée par l'intermédiaire de deux transistors MOS M19 et M15 montés en diode en série avec une source de courant M10 entre les deux bornes d'alimentation de la source de tension d'alimentation.

Un inconvénient de ce montage montré à la figure 11 de cet article, est que le courant de polarisation fourni par la source de courant M10 est perdu à travers les deux transistors montés en diode. Ce courant de polarisation n'est utilisé que pour déterminer des potentiels déterminés des transistors montés en diode, et ne contribue nullement au fonctionnement dans la branche active de l'oscillateur.

Dans le brevet CH 689 088, il est décrit un circuit oscillateur dans lequel le moyen de polarisation active est un amplificateur opérationnel à transconductance monté en suiveur de tension entre les bornes de drain et grille d'un transistor MOS d'une branche active du circuit oscillateur. Deux condensateurs C1, C2 sont reliés chacun respectivement à une borne du quartz K et à la masse, alors qu'un condensateur de compensation $C_K$ relie la sortie de l'amplificateur et une des bornes du quartz. Les condensateurs C1, C2 ont une grande valeur capacitive de manière à stabiliser l'amplificateur, ce qui constitue un inconvénient, car ils ne permettent pas de réaliser un circuit oscillateur de petite taille. De plus, aucune réduction de composants pour la polarisation des transistors et régulation de l'oscillation générée ne sont réalisées.

Dans la demande de brevet EP 2 073 377 A1, il est décrit un circuit oscillateur à quartz à polarisation active. Le circuit oscillateur comprend un inverseur formé de deux transistors complémentaires PMOS et NMOS, qui sont montés en série avec une première source de courant entre deux bornes d'une source de tension d'alimentation pour définir une branche active. La source du transistor PMOS est reliée à la première source de courant, alors que la source du transistor NMOS est reliée à une des bornes de la source de tension d'alimentation. Les drains des transistors sont reliés à une première électrode du quartz pour fournir par exemple un signal de sortie. Les grilles des transistors sont reliées à une seconde électrode du quartz. Un premier condensateur de déphasage est relié à la première électrode du quartz, alors qu'un second condensateur est relié à la seconde électrode du quartz.

Le circuit comprend encore entre les drains et grilles des transistors une pseudo-résistance réalisée par un transistor NMOS pour servir de polarisation active. La source de ce transistor de pseudo-résistance est reliée aux grilles des transistors complémentaires, alors que le drain de ce transistor de pseudo-résistance est relié aux drains des transistors complémentaires. La grille de ce transistor de pseudo-résistance est polarisée par une seconde source de courant de polarisation. Ce circuit oscillateur requiert donc une polarisation externe, c'est-à-dire qu'il doit y avoir des sources de courant externes pour le fonctionnement de ce circuit oscillateur, ce qui constitue un inconvénient.

On peut citer également le brevet US 7,598,821 B2, qui décrit un circuit oscillateur à quartz contrôlé en amplitude avec une grande gamme de tension et de température. Le circuit oscillateur comprend deux condensateurs connectés à chaque borne d'un quartz, des premier et second transistors actifs complémentaires formant un amplificateur inverseur, des premier et second moyens de polarisation des transistors actifs, une première source de courant formée par un transistor du même type que le second transistor actif, et des moyens de contrôle du courant pour le second moyen de polarisation. Dans des conditions stables de fonctionnement, le second moyen de polarisation fournit une tension de polarisation par la grille du second transistor actif correspondant à la tension de grille de transistor de la première source de courant à l'intérieur d'un écart de tension. Un inconvénient de ce circuit oscillateur est que la régulation d'amplitude et la polarisation de l'amplificateur inverseur ne sont pas combinées pour facilement introduire une modulation dans la régulation d'amplitude d'oscillation et réduire la consommation électrique.

De plus, les documents de brevet US 2007/188256 A1, US 2008/042770 A1, FR 2 305 056 A1, US 9 209 747 B1, US 6 278 338 B1, US 7 688 154 B1, JP S59 57171 A divulguent, eux aussi, des oscillateurs à quartz avec réglage d'amplitude.

RESUME DE L'INVENTION

L'invention a donc pour but de pallier aux inconvénients de l'état de la technique en fournissant un circuit oscillateur à quartz de type auto-polarisé facile à intégrer et combinant la régulation d'amplitude et la polarisation de l'étage inverseur en liaison au quartz.

A cet effet, l'invention concerne un circuit oscillateur à quartz de type auto-polarisé, qui comprend les caractéristiques définies dans la revendication indépendante 1.

Des formes d'exécution particulières du circuit oscillateur à quartz sont définies dans les revendications dépendantes 2 à 11.

Un avantage du circuit oscillateur selon l'invention est qu'il comprend une seule unité électronique ou ensemble de régulation d'amplitude, qui regroupe les fonctions source de courant, redresseur ou détecteur de crêtes et polarisation de l'amplificateur de la branche active du circuit oscillateur. Cela permet de réduire le nombre de composants pour le fonctionnement du circuit oscillateur et réduire également la consommation électrique pour concevoir ce circuit oscillateur à ultra faible puissance. Ce circuit oscillateur à quartz peut ainsi être utilisé pour fournir un signal de cadencement d'une base de temps dans le domaine de l'horlogerie.

Un avantage du circuit oscillateur est d'avoir une régulation d'amplitude avec une polarisation de la branche active du circuit oscillateur, qui comprend une modulation du courant de polarisation. Un contrôle de variation et régulation d'amplitude est obtenue par un étage de régulation d'amplitude, qui commande un transistor de polarisation par sa base ou sa grille en étant relié à une électrode d'entrée du quartz et à une entrée de l'amplificateur de la branche active.

Un avantage du circuit oscillateur réside dans le fait que l'amplificateur de la branche active de l'oscillateur peut comprendre en étant polarisé par le transistor de polarisation, au moins un transistor MOS ou un agencement d'un inverseur composé d'un transistor PMOS monté en série avec un transistor NMOS entre deux bornes de tension d'alimentation. Le quartz est relié d'une part en sortie aux drains des transistors NMOS et/ou PMOS et d'autre part en entrée aux grilles des NMOS et/ou PMOS directement ou par l'intermédiaire de condensateurs de filtrage. La borne d'entrée du quartz est connectée également à la grille du transistor de polarisation et à une grille d'un transistor MOS d'un premier miroir de courant de l'étage de régulation d'amplitude.

BREVE DESCRIPTION DES FIGURES

Les buts, avantages et caractéristiques du circuit oscillateur à quartz de type auto-polarisé apparaîtront mieux dans la description suivante sur la base de formes d'exécution non limitatives illustrées par les dessins sur lesquels :

la figure 1 représente un schéma bloc simplifié du circuit oscillateur à quartz de type auto-polarisé selon l'invention,

la figure 2 représente une première forme d'exécution du circuit oscillateur à quartz de type auto-polarisé selon l'invention,

la figure 3 représente une seconde forme d'exécution du circuit oscillateur à quartz de type auto-polarisé selon l'invention,

les figures 4a et 4b représentent une partie du circuit oscillateur de la seconde forme d'exécution et les signaux aux bornes du quartz et le courant du transistor d'auto-polarisation selon l'invention, et

les figures 5a et 5b représentent d'une part le courant nécessaire à un inverseur pour maintenir une amplitude d'oscillation du circuit oscillateur, et d'autre part l'évolution du courant de sortie d'un inverseur du circuit oscillateur.

## DESCRIPTION DETAILLEE

Dans la description suivante, tous les éléments du circuit oscillateur à quartz qui sont bien connus de l'homme du métier dans ce domaine technique ne seront relatés que de manière simplifiée. Il est principalement fait référence à un circuit oscillateur à quartz auto-polarisé susceptible de fournir des signaux d'horloge notamment pour une utilisation horlogère.

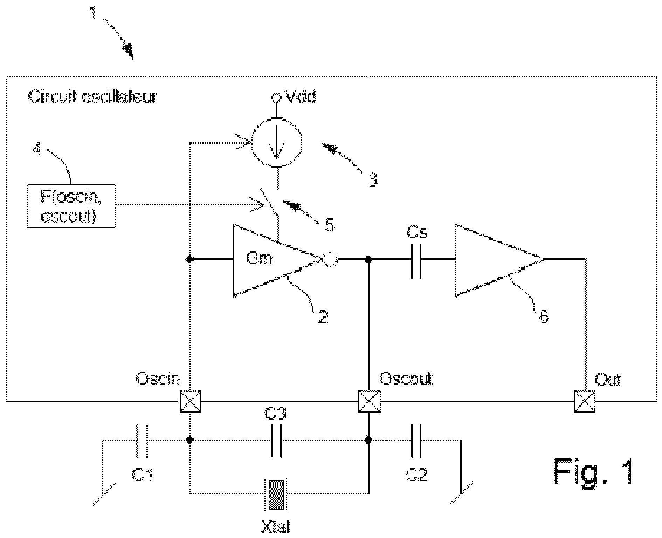

A la figure 1, il est représenté un schéma bloc simplifié du circuit oscillateur à quartz de type auto-polarisé 1 pour comprendre son principe de fonctionnement. Il est recherché d'introduire une modulation dans la partie de régulation d'amplitude du signal oscillant pour réduire la consommation électrique et également permettre une auto-polarisation de l'oscillateur à quartz. La modulation agit principalement sur le courant de polarisation de la branche active de l'oscillateur. Ainsi, le courant de polarisation comprend une composante de courant continue et une composante de courant alternative.

Le circuit oscillateur à quartz 1 peut être du type Pierce. Il comprend un quartz Xtal ou résonateur à quartz, un premier condensateur C1, qui est relié entre la première électrode du quartz Xtal liée à une borne de connexion Oscin du circuit intégré oscillateur, et la masse, et un second condensateur C2, qui est relié entre la seconde électrode du quartz Xtal liée à une borne de connexion Oscout du circuit intégré oscillateur, et la masse. Un troisième condensateur C3 dit parasite peut être monté en parallèle au quartz Xtal ou résonateur à quartz. Ce troisième condensateur C3 peut aussi faire partie intégrante du cristal de quartz. Normalement sans être visualisé à la figure 1, chaque condensateur C1, C2 et C3 comprend un condensateur externe relié aux bornes de connexion Oscin et Oscout et des condensateurs intégrés ajustables, ainsi que des condensateurs parasites dans le circuit intégré oscillateur. Les condensateurs externes au circuit intégré oscillateur sont référencés Cin et Cout sur les figures suivantes décrites ci-après. Les valeurs capacitives de ces condensateurs peuvent être de l'ordre de 1 pF ou inférieures.

Le circuit intégré oscillateur 1 comprend encore un amplificateur 2, qui peut être par exemple un amplificateur inverseur 2 à transconductance Gm. Cet amplificateur est relié au quartz Xtal par les bornes de connexion Oscin et Oscout. Une entrée de l'amplificateur 2 est reliée à la borne d'entrée Oscin, alors qu'une sortie de l'amplificateur 2 est reliée à la borne de sortie Oscout. La régulation d'amplitude de l'oscillation aux bornes du quartz Xtal est obtenue par un ensemble comprenant un modulateur 5 représenté par un commutateur sur la figure 1, qui est commandé par un bloc fonctionnel 4 dépendant de l'oscillation aux bornes du quartz Xtal, et une source de courant 3 contrôlée par un signal d'oscillation à la borne d'entrée Oscin. La source de courant 3 est reliée à la borne de tension d'alimentation Vdd et fournit une polarisation à l'amplificateur 2 par l'intermédiaire du modulateur 5. Le circuit oscillateur à quartz est donc auto-polarisé par l'ensemble fonctionnel de régulation d'amplitude.

Le circuit oscillateur à quartz 1 peut comprendre encore en sortie de l'amplificateur 2, un étage à décalage de niveau de tension. Cet étage à décalage de niveau de tension est composé d'un condensateur d'entrée Cs suivi par un amplificateur d'oscillation 6 pour fournir en sortie par une autre borne de sortie Out, un signal d'oscillation notamment pour le cadencement d'une base de temps.

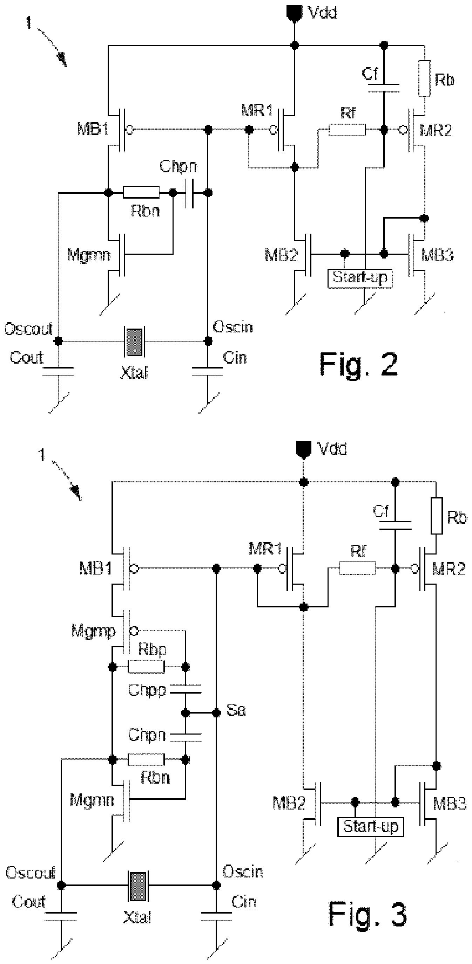

On comprendra mieux le fonctionnement de ce circuit oscillateur à quartz 1 en référence aux deux formes d'exécution présentées aux figures 2 et 3 suivantes.

A la figure 2, il est représenté une première forme d'exécution du circuit oscillateur à quartz 1 auto-polarisé. Le circuit oscillateur 1 est destiné à être relié entre une première borne et une seconde borne d'une source de tension d'alimentation. La première borne peut être la borne de tension d'alimentation Vdd et la seconde borne peut être la borne de masse, ou inversement.

Ce circuit oscillateur 1 comprend un amplificateur composé principalement d'un premier transistor Mgmn, qui est un transistor d'un premier type de conductivité, tel qu'un transistor MOS. De préférence, le premier transistor Mgmn est un transistor NMOS. Ce premier transistor Mgmn a sa source reliée à la seconde borne de la source de tension d'alimentation, qui est la borne de masse dans cette forme d'exécution. Le drain du premier transistor Mgmn est relié à une première électrode du quartz Xtal à la borne de sortie Oscout. Une première résistance Rbn peut être reliée entre le drain et la grille du premier transistor Mgmn et un premier condensateur Chpn peut être relié entre la grille et une seconde électrode du quartz Xtal à la borne d'entrée Oscin. Un condensateur de sortie Cout est relié entre la première électrode du quartz Xtal et la seconde borne de la source de tension d'alimentation, qui est la borne de masse, et un condensateur d'entrée Cin est relié entre la seconde électrode du quartz Xtal et la seconde borne de la source de tension d'alimentation, qui est la borne de masse. Généralement des condensateurs d'entrée Cin et de sortie Cout, ainsi que le quartz Xtal sont des composants externes au circuit intégré oscillateur.

La polarisation de l'amplificateur, c'est-à-dire du premier transistor Mgmn est fournie par un transistor de polarisation MB1, qui est un transistor d'un second type de conductivité, et de préférence dans cette première forme d'exécution un transistor PMOS. La source de ce transistor de polarisation MB1 est reliée à la première borne de la source de tension d'alimentation, qui est la borne de tension d'alimentation Vdd dans ce cas de figure, alors que le drain est relié au drain du premier transistor Mgmn et à la première électrode du quartz Xtal. La grille du transistor de polarisation MB1 est reliée à un étage de régulation d'amplitude à source de courant. La grille du transistor de polarisation MB1 est aussi reliée à la seconde électrode du quartz Xtal et à une borne du premier condensateur Chpn formant un nœud de connexion de contrôle de modulation du courant dans le transistor de polarisation MB1 comme expliqué ci-après.

Il est à noter qu'il peut aussi être envisagé de connecter directement la grille du premier transistor Mgmn à la seconde électrode du quartz Xtal à la borne d'entrée Oscin, ainsi qu'à la grille du transistor de polarisation MB1. La résistance Rbn et le condensateur Chpn servent avant tout de filtrage pour atténuer tout bruit parasite ou toute gigue pour l'obtention d'un signal oscillant à amplitude régulée aux bornes du quartz Xtal.

L'étage de régulation d'amplitude comprend tout d'abord un premier miroir de courant, qui est un miroir de courant de type MOS. Ce premier miroir de courant comprend un transistor d'un second type de conductivité, qui est un transistor PMOS monté en diode MR1, dont la source est reliée à la première borne de la source de tension d'alimentation, qui est ici la borne de tension d'alimentation Vdd. La grille du transistor monté en diode MR1 est reliée à la grille du transistor de polarisation MB1 et au nœud de connexion du premier condensateur Chpn et de la seconde électrode du quartz Xtal. La grille du transistor monté en diode MR1 est reliée à un côté d'une résistance de filtrage Rf. L'autre côté de cette résistance de filtrage Rf est reliée à la grille d'un transistor d'un second type de conductivité, qui est un transistor PMOS MR2 du premier miroir de courant et à une première électrode d'un condensateur filtrage Cf, dont une seconde électrode est reliée à la première borne de la source de tension d'alimentation, qui est ici la borne de tension d'alimentation Vdd. La source du transistor PMOS MR2 est reliée à la borne de tension d'alimentation Vdd via une résistance de base Rb, qui permet de déterminer le courant de régulation de l'étage de régulation d'amplitude. Le transistor monté en diode MR1 et le redresseur composé de la résistance de filtrage Rf et du condensateur de filtrage Cf constituent un détecteur de crêtes.

A titre informatif, on effectue le dimensionnement des éléments de filtrage Rf et Cf de telle sorte que la bande passante du filtre soit bien inférieure au dixième de la fréquence de résonance du quartz, qui dans ce cas, est à 3.2 kHz pour une fréquence du résonateur à environ 32.768 kHz. Une marge peut être prise par exemple à une fréquence de 560 Hz, qui est réalisable à l'aide d'une résistance Rf à 120 MOhms et un condensateur Cf à 4.7 pF.

L'étage de régulation d'amplitude comprend encore un second miroir de courant, qui est un miroir de courant d'un premier type de conductivité, tel que de type NMOS. Ce second miroir de courant comprend un transistor NMOS monté en diode MB3, dont la source est reliée à la seconde borne de la source de tension d'alimentation, qui est la borne de masse. Le drain de ce transistor monté en diode MB3 est relié au drain du transistor PMOS MR2 du premier miroir de courant. La grille du transistor monté en diode MB3, qui est reliée au drain, est reliée à la grille d'un transistor NMOS MB2 du second miroir de courant. La source de ce transistor NMOS MB2 est reliée à la seconde borne de la source de tension d'alimentation, qui est la borne de masse. Le drain de ce transistor NMOS MB2 est connecté au transistor monté en diode MR1 du premier miroir de courant et au nœud de connexion de contrôle de modulation du courant dans le transistor de polarisation MB1. Le courant de référence généré dans le transistor PMOS MR2 est ainsi miroité dans le second miroir de courant pour alimenter le transistor monté en diode PMOS MR1 afin de réguler l'amplitude d'oscillation par l'intermédiaire du transistor de polarisation MB1. Ainsi, l'ensemble fonctionnel de régulation d'amplitude regroupe les fonctions de source de courant, de redresseur ou détecteur de crêtes et de polarisation de l'amplificateur de la branche active du circuit oscillateur.

Comme représenté à la figure 2, il peut aussi être prévu un bloc de démarrage désigné Start-up pour la mise en fonction de l'étage de régulation d'amplitude. Ce bloc de démarrage est relié à la grille du transistor PMOS MR2 du premier miroir de courant et à la grille des transistors NMOS MB2 et MB3 du second miroir de courant. Ce bloc de démarrage ne sera pas décrit, mais est déjà connu notamment du livre de Messieurs E. Vittoz et J. Fellrath, intitulé "CMOS analog integrated circuits based on weak inversion operations" de IEEE J. Solid-State Circuits, vol. 12, no. 3, pages 224 à 231 de juin 1977.

A titre exemple, on peut utiliser un simple transistor natif conducteur pour une tension grille-source nulle. La grille est connectée à la masse du circuit, la source est connectée à la grille des transistors MB2 et MB3, et le drain est connecté à la grille du transistor MR2 en imposant ainsi au circuit de converger. Lorsque le circuit converge vers un point de fonctionnement, la tension grille-source est négative et bloque ainsi le transistor natif.

Il est encore à noter que le circuit oscillateur à quartz auto-polarisé 1 peut aussi être agencé inversement au montage présenté à la figure 2. Dans ces conditions, les transistors de type NMOS Mgmn, MB2, MB3 deviennent des transistors de type PMOS reliés à la borne de tension d'alimentation Vdd et les transistors de type PMOS MB1, MR1 et MR2 deviennent des transistors de type NMOS reliés à la masse. Le quartz Xtal et les condensateurs Cin et Cout sont donc reliés à la borne de tension d'alimentation Vdd.

Pour le fonctionnement adéquat de l'étage de régulation d'amplitude décrit ci-dessus, cela requiert de faire fonctionner les transistors PMOS MR1 et MR2 en faible inversion. Ainsi, la tension développée à la source du transistor PMOS MR2, et la différence de tension de la résistance Rb en assumant les transistors PMOS MR1 et MR2 avec la même tension de substrat seront comme définis dans l'équation suivante :

$$V_{sMR2} = u_t \cdot \ln[((W_{MR2}/L_{MR2})/(W_{MR1}/L_{MR1})) \cdot ((W_{MB3}/L_{MB3})/(W_{MB2}/L_{MB2}))]$$

où W définit la largeur du canal du transistor MOS, et L définit la longueur du canal du transistor MOS, et la composante ut est la tension thermodynamique.

La tension aux bornes de la résistance de base Rb sera en principe constante, ce qui n'est pas entièrement le cas de la tension sur la grille du transistor PMOS MR1 en fonction de l'oscillation aux bornes du quartz Xtal. Ainsi, il est formé un courant de référence à travers la résistance de base Rb et le transistor PMOS MR2, qui est défini selon l'équation suivante :

$$I_{ref} = u_t \cdot \ln[((W_{MR2}/L_{MR2})/(W_{MR1}/L_{MR1})) \cdot ((W_{MB3}/L_{MB3})/(W_{MB2}/L_{MB2}))]/Rb$$

Ce courant Iref est ensuite transmis à travers les miroirs de courant au transistor de polarisation PMOS MB1 selon un rapport défini. Dans la branche active de l'amplificateur par le premier transistor Mgmn, le courant de polarisation est un courant modulé sur une composante constante de courant. Lorsque l'oscillation débute aux bornes du quartz Xtal, la limite d'amplitude est prudemment choisie pour éviter que les transistors PMOS MR1 et MR2 sortent de la région de faible inversion souhaitée. Un simple critère est que :

$$V_{dd} - (V_{osc} + V_{gMR2}) \leq V_{Tp}$$

En théorie si la configuration du transistor PMOS est conservée, il peut être calculé que la tenson de grille du transistor PMOS MR2, c'est-à-dire $V_{gMR2}$ est :

$$V_{gMR2} = V_{dd} - u_t \cdot \ln[((W_{MR2}/L_{MR2})/(W_{MR1}/L_{MR1})) \cdot ((W_{MB3}/L_{MB3})/(W_{MB2}/L_{MB2}))]$$
$$- [V_{T0} + n \cdot u_t \cdot \ln(I_F)]$$

où $I_F$ est le courant d'inversion.

La régulation d'amplitude est aussi bien présentée dans le livre de Messieurs E. Vittoz et J. Fellrath, intitulé "CMOS analog integrated circuits based on weak inversion operations" de IEEE J. Solid-State Circuits, vol. 12, no. 3, pages 224 à 231 de juin 1977, qui est incorporé ici comme référence. Cela donne l'avantage au comportement non linéaire du transistor :

$$(I_D/I_{spec}) = e^{(vg - vt + |voscin| \cdot \sin(\omega t))/ut}$$

La composante continue du courant de drain est obtenue en moyennant cette équation sur une période :

$$(I_D/I_{spec}) = e^{(vg-vt)/ut} \cdot (1/2\pi) \int e^{((voscin/n \cdot ut) \cdot \sin(\omega t))} d\omega t \quad \text{intégrale de } -\pi \text{ à } +\pi$$

Cela mène analytiquement à une fonction tabulée, qui est appelée la fonction de Bessel modifiée d'ordre 0 { Io(x) } :

$$(I_D/I_{spec}) = e^{(vg-vt)/ut} \cdot (1 + v_1^2/2^2 + v_1^4/(2^2 \cdot 4^2) + v_1^6/(2^2 \cdot 4^2 \cdot 6^2) + \ldots)$$

Ainsi, il est proposé un courant, qui est dépendant de la fonction de Bessel de l'amplitude. A ce titre et comme exemple non limitatif, l'amplitude crête est, quant à elle, définie par un rapport de courants spécifiques, et selon les contraintes d'appariement, cela se traduit par la géométrie. Pour une amplitude de 60 mV crête, on a une fonction Io(x) = 2,1 par tabulation, x étant lui défini par [((W_{MR2}/L_{MR2})/(W_{MR1}/L_{MR1})) \cdot ((W_{MB3}/L_{MB3})/(W_{MB2}/L_{MB2}))]. On peut donc faire le choix de telle manière que WMR2/LMR2 = 21 · $W_{MR1}/L_{MR1}$ et $W_{MB3}/L_{MB3}$ = 10 · $W_{MB2}/L_{MB2}$.

A la figure 3, il est représenté une seconde forme d'exécution du circuit oscillateur à quartz 1 auto-polarisé. Il est à noter que les composants de cette figure 3, qui correspondent à ceux de la figure 2, portent les mêmes signes de référence. Comme la majeure partie des composants de cette seconde forme d'exécution sont similaires à ceux décrits en référence à la figure 2, uniquement les différences de ces circuits oscillateurs sont expliquées ci-après.

La différence essentielle de cette seconde forme d'exécution réside dans le fait que l'amplificateur dans la branche active du circuit oscillateur est un amplificateur inverseur à transconductance Gm. Cet amplificateur comprend donc un inverseur composé d'un premier transistor Mgmn d'un premier type de conductivité monté en série avec un second transistor Mgmp d'un second type de conductivité. Le premier transistor Mgmn est de préférence un transistor NMOS, et le second transistor Mgmp est de préférence un transistor PMOS.

Le premier transistor Mgmn a sa source reliée à la borne de masse dans cette seconde forme d'exécution. Le drain du premier transistor Mgmn est relié au drain du second transistor Mgmp et à une première électrode du quartz Xtal à la borne de sortie Oscout. Une première résistance Rbn peut être reliée entre le drain et la grille du premier transistor Mgmn et un premier condensateur Chpn peut être relié entre la grille du premier transistor et une seconde électrode du quartz Xtal à la borne d'entrée Oscin. Une seconde résistance Rbp peut être reliée entre le drain et la grille du second transistor Mgmp et un second condensateur Chpp peut être relié entre la grille du second transistor et la seconde électrode du quartz Xtal à la borne d'entrée Oscin. Un condensateur de sortie Cout est relié entre la première électrode du quartz Xtal et la borne de masse, et un condensateur d'entrée Cin est relié entre la seconde électrode du quartz Xtal et la borne de masse. Généralement des condensateurs d'entrée Cin et de sortie Cout, ainsi que le quartz Xtal sont des composants externes au circuit intégré oscillateur. Des condensateurs d'ajustage et parasites non représentés sont encore dans le circuit intégré oscillateur 1.

La polarisation de l'amplificateur est obtenue au moyen du transistor de polarisation MB1, d'un second type de conductivité, dont la source est reliée à la borne de tension d'alimentation Vdd, alors que le drain est relié à la source du second transistor PMOS Mgmp. Comme précédemment mentionné, la grille du transistor de polarisation MB1 est reliée à un étage de régulation d'amplitude à source de courant. La grille du transistor de polarisation MB1 est aussi reliée à la seconde électrode du quartz Xtal et à une borne du premier condensateur Chpn et à une borne du second condensateur Chpp formant un nœud de connexion Sa de contrôle de modulation du courant dans le transistor de polarisation MB1.

Il est à noter qu'il peut aussi être envisagé de connecter directement la grille du premier transistor Mgmn et la grille du second transistor Mgmp à la seconde électrode du quartz Xtal à la borne d'entrée Oscin, ainsi qu'à la grille du transistor de polarisation MB1. Les résistances Rbn et Rbp et les condensateurs Chpn et Chpp peuvent être retirés. Les résistances Rbn et Rbp et les condensateurs Chpn et Chpp servent avant tout de filtrage pour atténuer tout bruit parasite ou toute gigue pour l'obtention d'un signal oscillant à amplitude régulée aux bornes du quartz Xtal.

Il est encore à noter que tous les composants de l'étage de régulation d'amplitude à source de courant sont les mêmes que ceux décrits en référence à la figure 2. Ils ont donc déjà été décrits. De plus comme précédemment indiqué, il est envisageable d'inverser l'agencement des composants dans cette seconde forme d'exécution de la figure 3 du circuit oscillateur à quartz auto-polarisé 1. Dans ces conditions, les transistors de type NMOS Mgmn, MB2, MB3 deviennent des transistors de type PMOS reliés à la borne de tension d'alimentation Vdd et les transistors de type PMOS Mgmp, MB1, MR1 et MR2 deviennent des transistors de type NMOS reliés à la masse. Les condensateurs Cin et Cout, reliés au quartz Xtal, sont donc reliés à la borne de tension d'alimentation Vdd.

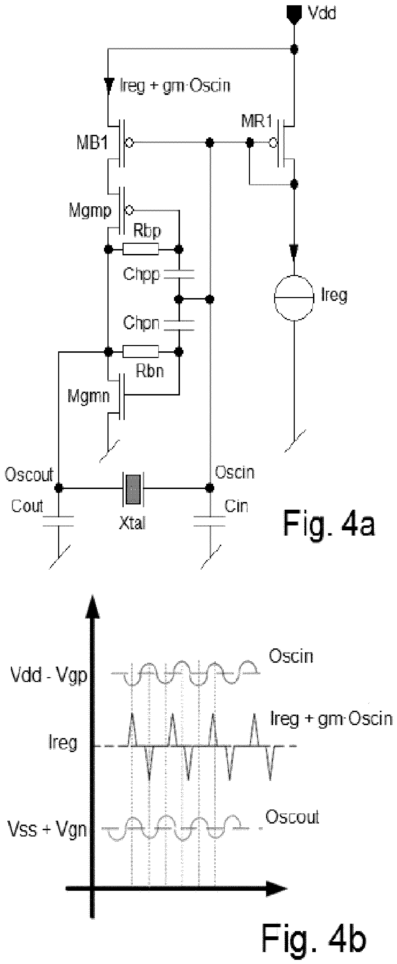

Pour comprendre la modulation de courant dans la branche active de l'oscillateur par l'intermédiaire du transistor de polarisation MB1, on peut se référer aux figures 4a et 4b. Le circuit représenté à la figure 4a reprend une partie du circuit oscillateur de la figure 3. L'étage de régulation d'amplitude est simplifié par le transistor monté en diode PMOS MR1 du premier miroir de courant et par une source de courant Ireg reliée au drain du transistor MR1. Le courant de polarisation Ireg + gm·Oscin par le transistor de polarisation MB1 est donc modulé au cours du temps selon la fréquence d'oscillation au niveau du quartz aux bornes Oscin et Oscout. Il y a une modulation de tension de grille du transistor de polarisation MB1 due à la modulation de régulation d'amplitude.

Comme représenté dans cette forme d'exécution de la figure 4a, il y a une opposition de phase entre les signaux Oscin and Oscout, qui est assurée par le montage inverseur avec les transistors Mgmp et Mgmn. La figure 4b représente la variation du courant de polarisation Ireg + gm·Oscin, et les tensions Oscin et Oscout en opposition de phase aux bornes d'entrée et de sortie. La tension Vgp est la tension de grille du transistor Mgmp, alors que la tension Vgn est la tension de grille du transistor Mgmn.

On remarque qu'avec un tel ensemble fonctionnel de régulation d'amplitude, qui regroupe les fonctions de source de courant, de redresseur et de polarisation de la branche active du circuit oscillateur, une réduction de composants est obtenue et de ce fait une réduction de la consommation électrique du circuit oscillateur.

Comme décrit sommairement en référence à la figure 1, il peut encore être prévu dans le circuit oscillateur à quartz auto-polarisé, un étage amplificateur à décalage de niveau de tension. Cet étage de sortie peut fournir un signal oscillant sur la base du signal d'oscillation à la borne d'entrée Oscin. L'étage de sortie à décalage de niveau de tension peut comprendre un montage inverseur connecté aux bornes de la tension d'alimentation. Ce montage inverseur peut être identique à l'amplificateur inverseur de la branche active de l'oscillateur. Ce montage inverseur comprend donc un transistor PMOS monté en série avec un transistor NMOS, et la connexion des filtres RC, dont une électrode des condensateurs est reliée à la borne d'entrée Oscin. Les drains des transistors PMOS et NMOS fournissent le signal oscillant de sortie.

A titre indicatif, le courant moyen de polarisation est inférieur à 30 nA, par exemple de l'ordre de 5 nA ou inférieur, et la tension d'alimentation peut être inférieure à 3 V par exemple de l'ordre de 0.6 V. La fréquence d'oscillation aux bornes du quartz Xtal est de 32.768 kHz avec une erreur instantanée contenue dans l'enveloppe du facteur de qualité.

Pour la question des tensions minimum, on peut écrire la loi de Kirchoff suivante :

$$Vdd - Vg_{MR1,2} - Vdsat_{MB2,MB3} - Vs_{MR2} = 0$$

où Vg est la tension de grille, Vd est la tension de drain et Vs est la tension de source, et cela revient à l'inéquation suivante :

$$Vdd \geq Vg_{MR1,2} + Vdsat_{MB2,MB3} + Vs_{MR2}$$

On peut aussi remplacer la tension à la source du transistor de MR2 selon l'inéquation suivante :

$$Vdd \geq Vg_{MR1,2} + Vdsat_{MB2,MB3} + u_t \cdot \ln((S_{MR2}/S_{MR3}) \cdot (S_{MB2}/S_{MB3}))$$

SMR2 correspond à WMR2/LMR2, SMR3 correspond à WMR3/LMR3, SMB2 correspond à WMB2/LMB2 et SMB3 correspond à WMB3/LMB3.

Dans une technologie CMOS à 0.18 $\mu$m (ALP18), il y a certaines flexibilités sur les tensions de seuil comme indiqué ci-dessous :

| Tension de seuil | NMOS | PMOS |
|---|---|---|
| 1.8V Dispositif standard | 533 mV | 523 mV |
| **1.8V Dispositif à faible Vt** | **366 mV** | **296 mV** |
| 3.3V Dispositif standard | 607 mV | 638 mV |

La tension de grille Vg$_{MR1,2}$ est environ une tension de seuil Vt comme indiqué dans l'équation suivante :

$$Vg_{MR1,2} = Vt + n \cdot u_t \cdot \ln(I_c)$$

Une hypothèse est comme suit :

$$u_t \cdot \ln((S_{T3}/S_{T1}) \cdot (S_{T2}/S_{T4}))$$

avec le rapport 21 où $3 \cdot u_t = 78$ mV à 25 °C.

Vdsat $= u_t \cdot (2 \cdot I_F^{1/2} + 4)$ où $4 \cdot u_t$ à $7 \cdot u_t$ est raisonnable.

| Inversion courant miroir | Vdd $\geq$ | NMOS | PMOS |
|---|---|---|---|
| Modéré ($I_F \approx 1$) | Vdd $\geq$ Vt$_{MR1,2}$ + 7·u$_t$ | 492 mV | **452 mV** |
| Fort ($I_F \approx 10$) | Vdd $\geq$ VtT$_{2,4}$+ 10·u$_t$ | 626 mV | 556 mV |

Comme le coefficient d'inversion est de 10 pour les courants de 5 nA, il est nécessaire de réaliser un transistor de 1 $\mu$m sur 1 mm pour le transistor NMOS (LVT) et de 1 $\mu$m sur 200 $\mu$m pour le transistor PMOS (LVT). Certaines mesures peuvent montrer qu'on peut faire un cœur d'oscillateur à 0.3 V.

Le circuit oscillateur à quartz auto-polarisé décrit ci-devant peut être avantageusement réalisé sous forme intégrée à l'exception du quartz Xtal et des condensateurs Cin et Cout dans un substrat de silicium normalement dopé P dans une technologie CMOS à 0.18 $\mu$m (ALP18). Ceci permet d'obtenir un circuit oscillateur auto-polarisé et avec régulation d'amplitude d'oscillation.

A titre d'exemple non limitatif pour le calcul des condensateurs intégrés de quartz standards, qui sont spécifiés par leur condensateur de charge $C_L$, les condensateurs sont dans une plage de valeurs comme indiquée dans le tableau ci-dessous. Pour des valeurs de condensateurs intégrés, on peut avoir une plage de 8 pF à 20 pF, ce qui est raisonnable pour l'intégration.

| $C_L$ | Condensateur de charge | 7 pF | 12.5 pF |
|---|---|---|---|
| $C_{IN}$ | Condensateur d'entrée | 14 pF | 25 pF |
| $C_{OUT}$ | Condensateur de sortie | 14 pF | 25 pF |
| $C_{PAD}$ | Condensateur de plage de contact PAD | 2.7 pF | 2.7 pF |
| $C_{OSC\_INPUT}$ | Condensateur d'entrée de l'amplificateur | 3 pF | 3 pF |
| $C_{IN\_ONO} = C_{IN} - C_{PAD} - C_{OSC\_INPUT}$ | Condensateur ONO d'entrée | 8.3 pF | 19.3 pF |
| $C_{OUT\_ONO} = C_{OUT} - C_{PAD}$ | Condensateur ONO de sortie | 11.3 pF | 15.4 pF |

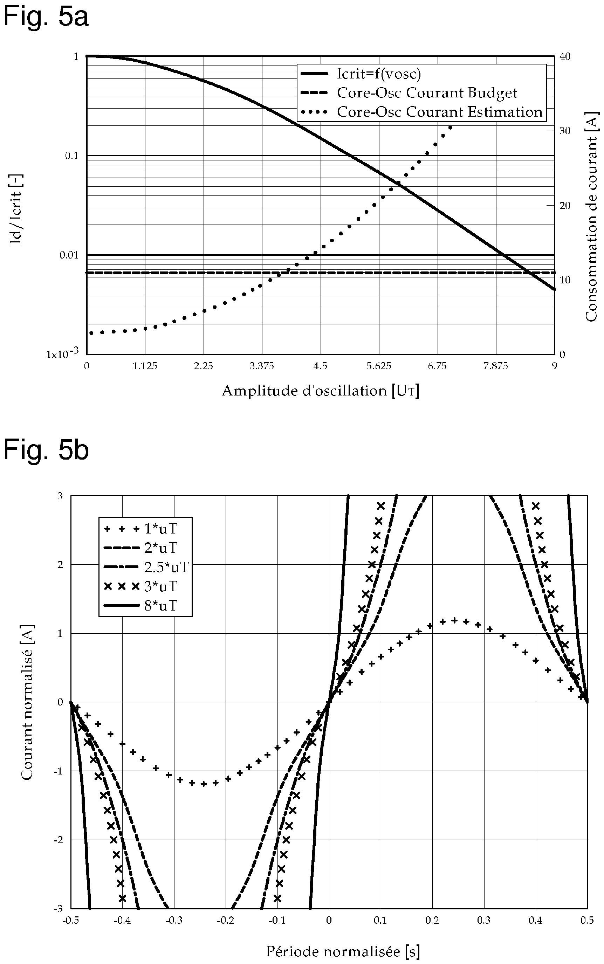

Pour comprendre la problématique de la transconductance gm en faible inversion des transistors MR1 et MR2 de la première source de courant de l'étage de régulation d'amplitude, il est fait référence aux figures 5a et 5b. Sur la figure 5a, la courbe en trait plein représente le courant nécessaire à un inverseur pour maintenir une amplitude d'oscillation définie et donc de présenter une impédance négative adaptée au résonateur.

$$I_{qcrit} = g_{mcrit} \cdot n \cdot u_t / 2$$

Ainsi plus l'amplitude est importante, moins le courant de polarisation de la transconductance est élevé. La transconductance peut en bénéficier d'effet géométrique en faible comme en forte inversion pour être maximisée de par la proportionnalité du courant spécifique.

La courbe représentée par des points sur la figure 5a représente la consommation dynamique du condensateur de base du quartz, tel que les condensateurs Cin - Cout sous condition que la valeur capacitive soit environ de 3 pF. La valeur de consommation est reportée sur l'axe vertical à droite. Si on souhaite par exemple diminuer la consommation dynamique de cet ensemble par exemple à 10 nA, la courbe en traits interrompus se réfère sur l'axe à droite. Alors il apparaît clairement la nécessité d'abaisser l'amplitude de l'oscillation de manière raisonnable à 2,3 fois la tension thermodynamique soit environ à 60 mV. L'amplitude de la plupart des produits disponibles sur le marché est supérieure à 8 fois la tension thermodynamique soit environ à 208 mV. Ces oscillateurs ne peuvent pas par ce biais consommer moins que 35 nA.

Sur la figure 5b, 8 fois la tension thermodynamique permettent largement d'avoir un régime de saturation et ainsi d'introduire une non-linéarité, qui permet la propagation du courant sous forme de Dirac. La figure 5b montre donc l'évolution du courant de sortie d'un inverseur. La forme d'onde est un sinus hyperbolique. Le courrant est normalisé au courant $I_{qcrit}$. La boucle de régulation d'amplitude permet d'empêcher de fournir un courrant supérieur une fois stabilisée. De ce fait, on peut définir un angle de conduction entre T=0 et T=Tangle.

De ce fait, lorsque l'une des courbes de la figure 5b croise 1 ou -1, le courant cesse donc d'être délivré. Ainsi, la valeur moyenne augmente avec un temps (angle) de conduction plus long. Une amplitude « standard » de 8 fois la tension thermodynamique permet d'obtenir une sorte de Dirac, mais 2.5 fois la tension thermodynamique conduit environ à 2.5 fois plus de temps, ce qui mène à un courant moyen plus élevé. Pour rétablir ces conditions, la connexion de Oscin et la grille du transistor de polarisation de la boucle de régulation permet de forcer une condition de courant en Dirac.

A partir de la description qui vient d'être faite, plusieurs variantes du circuit oscillateur à quartz de type auto-polarisé peuvent être conçues par l'homme du métier sans sortir du cadre de l'invention définie par les revendications. Il est noté que si les transistors sont des transistors bipolaires, la consommation est moins bonne qu'avec un agencement à transistors de type MOS.

## Revendications

**1.** Circuit oscillateur (1) à quartz de type auto-polarisé comprenant dans une branche active du circuit oscillateur, un amplificateur (2) avec une sortie reliée à une première électrode du quartz (Xtal) et une entrée reliée à une seconde électrode du quartz (Xtal), un condensateur de sortie (Cout) étant relié à la première électrode du quartz (Xtal) et un condensateur d'entrée (Cin) étant relié à la seconde électrode du quartz (Xtal), l'amplificateur (2) étant polarisé par un courant généré dans un ensemble de régulation d'amplitude, l'ensemble de régulation d'amplitude comprenant un étage de régulation d'amplitude ayant une source de courant et l'ensemble de régulation d'amplitude comprenant aussi un transistor de polarisation (MB1) en courant, qui est contrôlé par une grille du transistor par l'étage de régulation d'amplitude, et relié à l'amplificateur (2) pour le polariser, la seconde électrode du quartz (Xtal), qui est reliée à l'entrée de l'amplificateur (2), étant reliée à la grille du transistor de polarisation (MB1) et à l'étage de régulation d'amplitude de manière à varier le courant de polarisation à travers le transistor de polarisation (MB1) et réguler l'amplitude d'oscillation du quartz (Xtal),

**caractérisé en ce que** l'étage de régulation d'amplitude comprend un premier miroir de courant de type MOS, qui comprend un transistor d'un second type de conductivité monté en diode (MR1), dont une source est reliée à une première borne (Vdd) d'une source de tension d'alimentation, une grille du transistor monté en diode (MR1) est reliée à la grille du transistor de polarisation qui est aussi du second type de conductivité (MB1) et à la seconde électrode du quartz (Xtal), **en ce que** la grille du transistor monté en diode (MR1) est reliée à un côté d'une résistance de filtrage (Rf), alors qu'un autre côté de la résistance de filtrage (Rf) est reliée à une grille d'un autre transistor du second type de conductivité (MR2) du premier miroir de courant et à une première électrode d'un condensateur de filtrage (Cf), dont une seconde électrode est reliée à la première borne (Vdd) de la source de tension d'alimentation, **en ce qu'**une source de l'autre transistor du second type de conductivité (MR2) est reliée à la première borne (Vdd) de la source de tension d'alimentation via une résistance de base (Rb) pour déterminer un courant de régulation de la source de courant, **en ce que** l'étage de régulation d'amplitude comprend encore un second miroir de courant, qui comprend un premier transistor monté en diode d'un premier type de conductivité (MB3), dont une source est reliée à la seconde borne de la source de tension d'alimentation, et qui correspond à la source de courant, **en ce qu'**un drain de ce transistor monté en diode et qui est aussi du premier type de conductivité (MB3) est relié à un drain de l'autre transistor du second type de conductivité (MR2) du premier miroir de courant, **en ce qu'**une grille du transistor monté en diode du premier type de conductivité (MB3) est reliée à une grille d'un second transistor du premier type de conductivité (MB2) du second miroir de courant, **en ce qu'**une source de ce second transistor du premier type de conductivité (MB2) est reliée à la seconde borne de la source de tension d'alimentation, et **en ce qu'**un drain de ce second transistor du premier type de conductivité (MB2) est connecté au transistor monté en diode (MR1) du premier miroir de courant, à la seconde électrode du quartz (Xtal) et à la grille du transistor de polarisation du second type de conductivité (MB1) pour le contrôle du courant dans le transistor de polarisation (MB1).

2. Circuit oscillateur (1) à quartz selon la revendication 1, **caractérisé en ce que** l'amplificateur (2) et le transistor de polarisation (MB1) sont disposés en série entre deux bornes d'une source de tension d'alimentation (Vdd).

3. Circuit oscillateur (1) à quartz selon l'une des revendications 1 et 2, **caractérisé en ce que** l'amplificateur (2) comprend un premier transistor de type MOS (Mgmn) du premier type de conductivité, dont une grille est reliée du côté de l'entrée de l'amplificateur et un drain est relié du côté de la sortie de l'amplificateur.

4. Circuit oscillateur (1) à quartz selon la revendication 3, **caractérisé en ce qu'**un drain du transistor de polarisation (MB1) est relié au drain du premier transistor MOS, une source du premier transistor étant reliée à une borne de la source de tension d'alimentation, alors qu'une source du transistor de polarisation est reliée à une autre borne de la source de tension d'alimentation.

5. Circuit oscillateur (1) à quartz selon la revendication 4, **caractérisé en ce que** le transistor de polarisation (MB1) est un transistor PMOS, dont la source est reliée à la borne de tension d'alimentation (Vdd), et **en ce que** le premier transistor (Mgmn) est un transistor NMOS, dont la source est reliée à la borne de masse.

6. Circuit oscillateur (1) à quartz selon la revendication 5, **caractérisé en ce qu'**une première résistance (Rbn) est reliée entre le drain et la grille du premier transistor (Mgmn), et **en ce qu'**un premier condensateur (Chpn) est relié entre la grille et la seconde électrode du quartz (Xtal), ainsi qu'à la grille du transistor de polarisation (MB1).

7. Circuit oscillateur (1) à quartz selon la revendication 3, **caractérisé en ce que** l'amplificateur (2) comprend encore un second transistor (Mgmp) de type MOS du second type de conductivité, dont une grille est reliée du côté de l'entrée de l'amplificateur et un drain est relié du côté de la sortie de l'amplificateur, les premier et second transistors (Mgmn, Mgmp) étant montés en série avec le transistor de polarisation (MB1) entre les deux bornes de la source de tension d'alimentation.

**EP 3 407 486 B1**

8. Circuit oscillateur (1) à quartz selon la revendication 7, **caractérisé en ce que** le premier transistor (Mgmn) est un transistor NMOS, dont la source est reliée à une borne de masse, **en ce que** le second transistor (Mgmp) est un transistor PMOS, dont une source est reliée à un drain du transistor de polarisation (MB1), et un drain est relié au drain du premier transistor NMOS (Mgmn), et **en ce qu'**une source du transistor de polarisation est reliée à une borne de tension d'alimentation (Vdd).

9. Circuit oscillateur (1) à quartz selon la revendication 8, **caractérisé en ce qu'**une première résistance (Rbn) est reliée entre le drain et la grille du premier transistor (Mgmn), **en ce qu'**un premier condensateur (Chpn) est relié entre la grille du premier transistor et la seconde électrode du quartz (Xtal), ainsi qu'à la grille du transistor de polarisation (MB1), **en ce qu'**une seconde résistance (Rbp) est reliée entre le drain et la grille du second transistor (Mgmp), et **en ce qu'**un second condensateur (Chpp) est relié entre la grille du second transistor et la seconde électrode du quartz (Xtal), ainsi qu'à la grille du transistor de polarisation (MB1).

10. Circuit oscillateur (1) à quartz selon la revendication 1, **caractérisé en ce que** le premier miroir de courant est de type PMOS avec un transistor PMOS monté en diode (MR1), dont la source est reliée à une borne de tension d'alimentation (Vdd), la grille du transistor PMOS monté en diode (MR1) est reliée à la grille du transistor de polarisation PMOS (MB1) et à la seconde électrode du quartz (Xtal), **en ce que** la grille du transistor monté en diode (MR1) est reliée à un côté de la résistance de filtrage (Rf), alors qu'un autre côté de la résistance de filtrage (Rf) est reliée à la grille d'un autre transistor PMOS (MR2) du premier miroir de courant et à la première électrode du condensateur de filtrage (Cf), dont la seconde électrode est reliée à la borne de tension d'alimentation (Vdd), **en ce que** la source de l'autre transistor PMOS (MR2) est reliée à la borne de tension d'alimentation (Vdd) via la résistance de base (Rb) pour déterminer le courant de régulation de la source de courant.

11. Circuit oscillateur (1) à quartz selon la revendication 10, **caractérisé en ce que** l'étage de régulation d'amplitude est agencé pour faire fonctionner les transistors PMOS (MR1, MR2) en faible inversion.


**Patentansprüche**

1. Quarz-Oszillatorschaltung (1) des Typs autopolarisiert, umfassend in einem aktiven Zweig der Oszillatorschaltung einen Verstärker (2) mit einem mit einer ersten Quarzelektrode (Xtal) verbundenen Ausgang und mit einem mit einer zweiten Quarzelektrode (Xtal) verbundenen Eingang, einen Ausgangskondensator (Cout), der mit der ersten Quarzelektrode (Xtal) verbunden ist, und einen Eingangskondensator (Cin), der mit der zweiten Quarzelektrode (Xtal) verbunden ist, wobei der Verstärker (2) durch einen Strom vorgespannt ist, der in einem Amplitudenregelsatz erzeugt wird, wobei der Amplitudenregelsatz eine Amplitudenregelstufe mit einer Stromquelle umfasst und wobei der Amplitudenregelsatz ferner einen Stromvorspannungstransistor (MB1) umfasst, der über ein Gate des Transistors durch die Amplitudenregelstufe gesteuert wird und mit dem Verstärker (2) verbunden ist, um ihn vorzuspannen, wobei die zweite Quarzelektrode (Xtal), die mit dem Eingang des Verstärkers (2) verbunden ist, mit dem Gate des Vorspannungstransistors (MB1) und mit der Amplitudenregelstufe derart verbunden ist, dass der Vorspannungsstrom durch den Vorspannungstransistor (MB1) verändert wird und die Schwingungsamplitude des Quarzes (Xtal) geregelt wird,
**dadurch gekennzeichnet, dass** die Amplitudenregelstufe einen ersten Stromspiegel des MOS-Typs enthält, der einen Transistor (MR1) in Diodenschaltung eines zweiten Leitfähigkeitstyps enthält, dessen Source mit dem ersten Anschluss (Vdd) einer Versorgungsspannungsquelle verbunden ist, während ein Gate des Transistors (MR1) in Diodenschaltung mit dem Gate des Vorspannungstransistors (MB1), der ebenfalls vom zweiten Leitfähigkeitstyp ist, und mit der zweiten Quarzelektrode (Xtal) verbunden ist, dass das Gate des Transistors (MR1) in Diodenschaltung mit einer Seite eines Filterwiderstands (Rf) verbunden ist, während eine andere Seite des Filterwiderstands (Rf) mit einem Gate eines weiteren Transistors (MR2) des zweiten Leitfähigkeitstyps des ersten Stromspiegels und mit einer ersten Elektrode eines Filterkondensators (Cf) verbunden ist, dessen zweite Elektrode mit dem ersten Anschluss (Vdd) der Versorgungsspannungsquelle verbunden ist, dass eine Source des weiteren Transistors (MR2) des zweiten Leitfähigkeitstyps mit dem ersten Anschluss (Vdd) der Versorgungsspannungsquelle über einen Basiswiderstand (Rb) zur Bestimmung eines Regelstroms der Stromquelle verbunden ist, dass die Amplitudenregelstufe ferner einen zweiten Stromspiegel umfasst, der einen ersten Transistor (MB3) in Diodenschaltung eines ersten Leitfähigkeitstyps enthält, dessen Source mit dem zweiten Anschluss der Versorgungsspannungsquelle verbunden ist und der der Stromquelle entspricht, dass ein Drain dieses Transistors (MB3) in Diodenschaltung, der ebenfalls vom ersten Leitfähigkeitstyp ist, mit einem Drain des weiteren Transistors (MR2) des zweiten Leitfähigkeitstyps des ersten Stromspiegels verbunden ist, dass ein Gate des Transistors (MB3) in Diodenschaltung des ersten Leitfähigkeitstyps mit einem Gate (MB2) eines zweiten Transistors des ersten Leitfähigkeitstyps des zweiten Stromspiegels verbunden

**11**

ist, dass eine Source dieses zweiten Transistors (MB2) des ersten Leitfähigkeitstyps mit dem zweiten Anschluss der Versorgungsspannungsquelle verbunden ist und dass ein Drain dieses zweiten Transistors (MB2) des ersten Leitfähigkeitstyps mit dem Transistor (MR1) in Diodenschaltung des ersten Stromspiegels, mit der zweiten Quarzelektrode (Xtal) und mit dem Gate des Vorspannungstransistors (MB1) des zweiten Leitfähigkeitstyps verbunden ist, um den Strom in dem Vorspannungstransistor (MB1) zu steuern.

2.  Quarz-Oszillatorschaltung (1) nach Anspruch 1, **dadurch gekennzeichnet, dass** der Verstärker (2) und der Vorspannungstransistor (MB1) zwischen zwei Anschlüssen einer Versorgungsspannungsquelle (Vdd) in Reihe geschaltet sind.

3.  Quarz-Oszillatorschaltung (1) nach einem der Ansprüche 1 und 2, **dadurch gekennzeichnet, dass** der Verstärker (2) einen ersten MOS-Transistor (Mgmn) des ersten Leitfähigkeitstyps umfasst, dessen Gate mit der Seite des Eingangs des Verstärkers verbunden ist und dessen Drain mit der Seite des Ausgangs des Verstärkers verbunden ist.

4.  Quarz-Oszillatorschaltung nach Anspruch 3, **dadurch gekennzeichnet, dass** ein Drain des Vorspannungstransistors (MB1) mit dem Drain des ersten MOS-Transistors verbunden ist und eine Source des ersten Transistors mit einem Anschluss der Versorgungsspannungsquelle verbunden ist, während eine Source des Vorspannungstransistors mit einem anderen Anschluss der Versorgungsspannungsquelle verbunden ist.

5.  Quarz-Oszillatorschaltung (1) nach Anspruch 4, **dadurch gekennzeichnet, dass** der Vorspannungstransistor (MB1) ein PMOS-Transistor ist, dessen Source mit dem Versorgungsspannungsanschluss (Vdd) verbunden ist, und dass der erste Transistor (Mgmn) ein NMOS-Transistor ist, dessen Source mit dem Masseanschluss verbunden ist.

6.  Quarz-Oszillatorschaltung (1) nach Anspruch 5, **dadurch gekennzeichnet, dass** ein erster Widerstand (Rbm) zwischen den Drain und das Gate des ersten Transistors (Mgmn) geschaltet ist und dass ein erster Kondensator (Chpn) zwischen das Gate und die zweite Quarzelektrode (Xtal) geschaltet ist und mit dem Gate des Vorspannungstransistors (MB1) verbunden ist.

7.  Quarz-Oszillatorschaltung (1) nach Anspruch 3, **dadurch gekennzeichnet, dass** der Verstärker (2) ferner einen zweiten MOS-Transistor (Mgmp) des zweiten Leitfähigkeitstyps umfasst, dessen Gate mit der Seite des Eingangs des Verstärkers verbunden ist und dessen Drain mit der Seite des Ausgangs des Verstärkers verbunden ist, wobei der erste und der zweite Transistor (Mgmn, Mgmp) zwischen den beiden Anschlüssen der Versorgungsspannungsquelle mit dem Vorspannungstransistor (MB1) in Reihe geschaltet sind.

8.  Quarz-Oszillatorschaltung (1) nach Anspruch 7, **dadurch gekennzeichnet, dass** der erste Transistor (Mgmn) ein NMOS-Transistor ist, dessen Source mit einem Masseanschluss verbunden ist, dass der zweite Transistor (Mgmp) ein PMOS-Transistor ist, dessen Source mit einem Drain des Vorspannungstransistors (MB1) verbunden ist und dessen Drain mit dem Drain des ersten NMOS-Transistors (Mgmn) verbunden ist, und dass eine Source des Vorspannungstransistors mit einem Versorgungsspannungsanschluss (Vdd) verbunden ist.

9.  Quarz-Oszillatorschaltung (1) nach Anspruch 8, **dadurch gekennzeichnet, dass** ein erster Widerstand (Rbn) zwischen den Drain und das Gate des ersten Transistors (Mgmn) geschaltet ist, dass ein erster Kondensator (Chpn) zwischen das Gate des ersten Transistors und die zweite Quarzelektrode (Xtal) geschaltet ist und mit dem Gate des Vorspannungstransistors (MB1) verbunden ist, dass ein zweiter Widerstand (Rbp) zwischen den Drain und das Gate des zweiten Transistors (Mgmp) geschaltet ist und dass ein zweiter Kondensator (Chpp) zwischen das Gate des zweiten Transistors und die zweite Quarzelektrode (Xtal) geschaltet ist und mit dem Gate des Vorspannungstransistors (MB1) verbunden ist.

10. Quarz-Oszillatorschaltung (1) nach Anspruch 1, **dadurch gekennzeichnet, dass** der erste Stromspiegel vom PMOS-Typ ist und einen PMOS-Transistor (MR1) in Diodenschaltung umfasst, dessen Source mit einem Versorgungsspannungsanschluss (Vdd) verbunden ist, wobei das Gate des PMOS-Transistors (MR1) in Diodenschaltung mit dem Gate des PMOS-Vorspannungstransistors (MB1) und mit der zweiten Quarzelektrode (Xtal) verbunden ist, dass das Gate des Transistors (MR1) in Diodenschaltung mit einer Seite des Filterwiderstands (Rf) verbunden ist, während eine andere Seite des Filterwiderstands (Rf) mit dem Gate eines weiteren PMOS-Transistors (MR2) des ersten Stromspiegels und mit der ersten Elektrode des Filterkondensators (Cf) verbunden ist, dessen zweite Elektrode mit dem Versorgungsspannungsanschluss (Vdd) verbunden ist, und dass die Source des weiteren PMOS-Transistors (MR2) mit dem Versorgungsspannungsanschluss (Vdd) über den Basiswiderstand (Rb) verbunden ist, um den Regelstrom der Stromquelle zu bestimmen.

**11.** Quarz-Oszillatorschaltung (1) nach Anspruch 10, **dadurch gekennzeichnet, dass** die Amplitudenregelstufe dazu vorgesehen ist, die PMOS-Transistoren (MR1, MR2) mit geringer Inversion zu betreiben.

**Claims**

**1.** Quartz oscillator circuit (1) of the self-polarised type, comprising, in an active branch of the oscillator circuit, an amplifier (2) with an output which is connected to a first electrode of the quartz (Xtal) and an input which is connected to a second electrode of the quartz (Xtal), an output capacitor (Cout) being connected to the first electrode of the quartz (Xtal) and an input capacitor (Cin) being connected to the second electrode of the quartz (Xtal), the amplifier (2) being polarised by a current which is generated in an amplitude regulation assembly, the amplitude regulation assembly comprising an amplitude regulation stage having a current source and the amplitude regulation assembly further comprising a polarisation transistor (MB1) of current which is controlled by a gate of the transistor via the amplitude regulation stage and connected to the amplifier (2), in order to polarise it, the second electrode of the quartz (Xtal), which is connected to the amplifier input (2), being connected to the gate of the polarisation transistor (MB1) and to the amplitude regulation stage so as to vary the polarisation current through the polarisation transistor (MB1) and to regulate the oscillation amplitude of the quartz (Xtal),
**characterised in that** the amplitude regulation stage comprises a first current mirror of a MOS type which comprises a diode-connected transistor (MR1) of a second type of conductivity, one source of which is connected to a first terminal (Vdd) of a supply voltage source, a gate of the diode-connected transistor (MR1) is connected to the gate of the polarisation transistor (MB1) which is also of the second type of conductivity and to the second electrode of the quartz (Xtal), **in that** the gate of the diode-connected transistor (MR1) is connected to one side of a filter resistor (Rf) whilst another side of the filter resistor (Rf) is connected to a gate of another transistor (MR2) of the second type of conductivity of the first current mirror and to a first electrode of a filter capacitor (Cf), a second electrode of which is connected to the first terminal (Vdd) of the supply voltage source, **in that** a source of the other transistor (MR2) of the second type of conductivity is connected to the first terminal (Vdd) of the supply voltage source via a base resistor (Rb) in order to determine a regulation current of the current source, **in that** the amplitude regulation stage further comprises a second current mirror, which comprises a first diode-connected transistor (MB3) of a first type of conductivity, a source of which is connected to the second terminal of the supply voltage source and which corresponds to the current source, **in that** a drain of this diode-connected transistor (MB3) and which is also of the first type of conductivity is connected to a drain of the other transistor (MR2) of the second type of conductivity of the first current mirror, **in that** a gate of the diode-connected transistor (MB3) of the first type of conductivity is connected to a gate of a second transistor (MB2) of the first type of conductivity of the second current mirror, **in that** a source of this second transistor (MB2) of the first type of conductivity is connected to the second terminal of the supply voltage source, and **in that** a drain of this second transistor (MB2) of the first type of conductivity is connected to the diode-connected transistor (MR1) of the first current mirror, to the second electrode of the quartz (Xtal) and to the gate of the polarisation transistor (MB1) of the second type of conductivity for control of the current in the polarisation transistor (MB1).

**2.** Quartz oscillator circuit (1) according to claim 1, **characterised in that** the amplifier (2) and the polarisation transistor (MB1) are disposed in series between two terminals of a supply voltage source (Vdd).

**3.** Quartz oscillator circuit (1) according to one of claims 1 and 2, **characterised in that** the amplifier (2) comprises a first transistor of the MOS type (Mgmn) of the first type of conductivity, a gate of which is connected on the input side of the amplifier and a drain is connected on the output side of the amplifier.

**4.** Quartz oscillator circuit (1) according to claim 3, **characterised in that** a drain of the polarisation transistor (MB1) is connected to the drain of the first MOS transistor, a source of the first transistor being connected to a terminal of the supply voltage source, whilst a source of the polarisation transistor is connected to another terminal of the supply voltage source.

**5.** Quartz oscillator circuit (1) according to claim 4, **characterised in that** the polarisation transistor (MB1) is a PMOS transistor, the source of which is connected to the supply voltage terminal (Vdd), and **in that** the first transistor (Mgmn) is a NMOS transistor, the source of which is connected to the earth terminal.

**6.** Quartz oscillator circuit (1) according to claim 5, **characterised in that** a first resistor (Rbn) is connected between the drain and the gate of the first transistor (Mgmn), and **in that** a first capacitor (Chpn) is connected between the gate and the second electrode of the quartz (Xtal), and also to the gate of the polarisation transistor (MB1).

7. Quartz oscillator circuit (1) according to claim 3, **characterised in that** the amplifier (2) comprises also a second transistor (Mgmp) of the MOS type of the second type of conductivity, a gate of which is connected on the input side of the amplifier and a drain is connected on the side of the amplifier output, the first and second transistors (Mgmn, Mgmp) being connected in series with the polarisation transistor (MB1) between the two terminals of the supply voltage source.

8. Quartz oscillator circuit (1) according to claim 7, **characterised in that** the first transistor (Mgmn) is a NMOS transistor, the source of which is connected to an earth terminal, **in that** the second transistor (Mgmp) is a PMOS transistor, a source of which is connected to a drain of the polarisation transistor (MB1), and a drain is connected to the drain of the first NMOS transistor (Mgmn), and **in that** a source of the polarisation transistor is connected to a supply voltage terminal (Vdd).

9. Quartz oscillator circuit (1) according to claim 8, **characterised in that** a first resistor (Rbn) is connected between the drain and the gate of the first transistor (Mgmn), **in that** a first capacitor (Chpn) is connected between the gate of the first transistor and the second electrode of the quartz (Xtal), and also to the gate of the polarisation transistor (MB1), **in that** a second resistor (Rbp) is connected between the drain and the gate of the second transistor (Mgmp), and **in that** a second capacitor (Chpp) is connected between the gate of the second transistor and the second electrode of the quartz (Xtal), and also to the gate of the polarisation transistor (MB1).

10. Quartz oscillator circuit (1) according to claim 1, **characterised in that** the first current mirror is of a PMOS type which comprises a diode-connected PMOS transistor (MR1), the source of which is connected to a supply voltage terminal (Vdd), the gate of the diode-connected PMOS transistor (MR1) is connected to the gate of the PMOS polarisation transistor (MB1) and to the second electrode of the quartz (Xtal), **in that** the gate of the diode-connected transistor (MR1) is connected to one side of the filter resistor (Rf) whilst another side of the filter resistor (Rf) is connected to the gate of another PMOS transistor (MR2) of the first current mirror and to the first electrode of the filter capacitor (Cf), the second electrode of which is connected to the supply voltage terminal (Vdd), **in that** the source of the other PMOS transistor (MR2) is connected to the supply voltage terminal (Vdd) via the base resistor (Rb) in order to determine the regulation current of the current source.

11. Quartz oscillator circuit (1) according to claim 10, **characterised in that** the amplitude regulation stage is arranged to operate the PMOS transistors (MR1, MR2) in weak inversion.

Fig. 1

Fig. 2

Fig. 3

Fig. 4a

Fig. 4b

## Fig. 5a

## Fig. 5b

## RÉFÉRENCES CITÉES DANS LA DESCRIPTION

**Documents brevets cités dans la description**

- CH 623450
- CH 689088
- EP 2073377 A1
- US 7598821 B2
- US 2007188256 A1
- US 2008042770 A1
- FR 2305056 A1
- US 9209747 B1
- US 6278338 B1
- US 7688154 B1
- JP S5957171 A

**Littérature non-brevet citée dans la description**

- **ERIC A. VITTOZ.** Quartz oscillators for watches. *les actes du dixième Congrès International de Chronométrie,* 1979, vol. 3, 131-140
- **ERIC A. VITTOZ.** High-performance crystal oscillator circuits : Theory and application. *le journal IEEE des circuits à l'état solide, centre du service IEEE,* 01 Juin 1988, vol. 23 (3
- **MESSIEURS E. VITTOZ ; J. FELLRATH.** CMOS analog integrated circuits based on weak inversion operations. *IEEE J. Solid-State Circuits,* Juin 1977, vol. 12 (3), 224-231